# EUROPEAN PATENT SPECIFICATION

(11) **EP 1 376 690 B1**
(45) Date of publication and mention of the grant of the patent: **01.08.2007**
(21) Application number: 03013356.5
(22) Date of filing: 16.06.2003
(51) Int. Cl.: H01L 23/48, H01L 23/13, H01L 23/051, H01L 25/07, H01L 23/00

(54) **Pressure-contact type semiconductor device**
Halbleiterbauelement mit Druckkontakt
Dispositif semi-conducteur avec contact à pression

(30) Priority: 20.06.2002 JP 2002180573
(43) Date of publication of application: 02.01.2004
(73) Proprietor: KABUSHIKI KAISHA TOSHIBA, Tokyo 105-8001 (JP)
(72) Inventor: Katazawa, Hideaki, Intellectual Property Division, Minato-ku, Tokyo 105-8001 (JP); Hasegawa, Shigeru, Intellectual Property Division, Minato-ku, Tokyo 105-8001 (JP); Hiyoshi, Michiaki, Intellectual Property Division, Minato-ku, Tokyo 105-8001 (JP)
(74) Representative: HOFFMANN EITLE

(56) References cited:
- EP-A- 0 285 074
- EP-A- 0 702 406
- DE-A- 10 048 436
- US-B1- 6 281 569

## Description

This application is based upon and claims the benefit of priority from the prior Japanese Patent Application No. 2002-180573 filed on June 20, 2002.

### BACKGROUND

### 1. FIELD OF THE INVENTION

The present invention relates to a pressure-contact type semiconductor device having a structure for bringing semiconductor chips into pressure-contact by heat buffer plates, metal electrode plates, and so on, and more particularly, to a pressure-contact type semiconductor device suitable for enhancing thermal fatigue resistance.

### 2. DESCRIPTION OF THE RELATED ART

As high current and high withstand voltage power switching elements, currently manufactured and used are those having such a structure that a plurality of semiconductor chips such as IGBTs (insulated gate bipolar transistors) are arranged in parallel and brought into pressure-contact by heat buffer plates, metal electrode plates, and so on to reduce heat resistance (pressure-contact type semiconductor devices).

In thus structured pressure-contact type semiconductor devices, pressure-contact and heat generation induce gradual thermal fatigue of especially the metal electrode plates, resulting in plastic deformation thereof.

The present invention is made in consideration of the above circumstances, and its object is to provide a pressure-contact type semiconductor device capable of enhancing thermal fatigue resistance in a pressure-contact type semiconductor device having the structure for bringing semiconductor chips into pressure-contact by heat buffer plates, metal electrode plates, and so on.

European patent application publication EP 0702406 discloses a press-contact type semiconductor device comprising multiple semiconductor substrates, the periphery of which being enclosed by the chip frame of insulating resin, a first electrode plate and a second electrode plate. The present invention arranges the semiconductor substrates on a plane so as to abut against the chip frame with each other, which is press-contacted from the upper and the lower sides by the first electrode plate and the second electrode plate.

European patent application publication EP 0285074 discloses a press-contact type semiconductor device with a soft metal plate, having substantially the equal hardness as emitter electrodes formed of soft metal, disposed between the emitter electrodes and a heat buffer metal plate formed of hard metal, arranged such that pressure applied to the emitter electrodes is shared by the soft metal plate, so as to reduce the thermal fatigue of the emitter electrodes.

United States patent US 6,281,569 discloses a pressure contact semiconductor device which comprises a first main electrode plate, a second main electrode plate facing the first main electrode plate, an insulating enclosure for holding the periphery of each of the first and second main electrode plates in such a manner that the first and second main electrode plates face each other, a gate terminal provided so as to penetrate the enclosure, a gate electrode plate which is insulatively provided on the main surface of the first main electrode facing the second main electrode and which is electrically connected to the gate terminal, pressure-contact pins which are insulatively provided on the main surface of the first main electrode and which are electrically connected to the gate electrode plate, and semiconductor chips which are arranged in such a manner that the chips are sandwiched and pressed by the first and second main electrode plates and which each have a first and a second main electrode in pressure-contact with the first and second main electrode plates, respectively, and a gate electrode with which the corresponding one of the pressure-contact pins comes into pressure-contact.

### SUMMARY

The invention provides a pressure-contact type semiconductor device according to claim 1, comprising a plurality of semiconductor chips, a first heat buffer plate provided on one surface side of the plural semiconductor chips, a first metal electrode plate provided on the first heat buffer plate on a side opposite the plural semiconductor chips, a plurality of second heat buffer plates provided on the other surface sides of the plural semiconductor chips respectively, and a second metal electrode plate provided on the plural second heat buffer plates on a side opposite to the plural semiconductor chip sides and having projections facing and being in contact with the plural second heat buffer plates respectively and a pedestal portion being a base of the projections, characterised in that: to create a region which alleviates elastic deformation of the first heat buffer plate, the first heat buffer plate has a shape not extending outside a line connecting utmost outer positions of the plural semiconductor chips, and a surface of the first electrode plate opposite a surface facing the first heat buffer plate has a shape extending substantially outside the line connecting utmost outer positions of the plural semiconductor chips.

### BRIEF DESCRIPTION OF THE DRAWINGS

The present invention will be described with reference to the drawings, but these drawings are to be considered in all respects as illustrative and not restrictive of the scope of the present invention.
FIG. 1A and FIG. 1B are schematic views showing the structure of an example of a pressure-contact type semiconductor device.
FIG. 2 is a top view of a metal electrode plate 5 shown In FIG. 1A and FIG. 1B.
FIG. 3A and FIG. 3B are schematic views showing the structure of an example of a pressure-contact type semiconductor device.
FIG. 4 is a top view of a metal electrode plate 15 shown in FIG. 3A and FIG. 3B.
FIG. 5A and FIG. 5B are schematic views showing the structure of a pressure-contact type semiconductor device according to an embodiment of the present invention.
FIG. 6 is a top view of a heat buffer plate 14 shown in FIG. 5A and FIG. 5B.
FIG. 7A and FIG. 7B are schematic views showing the structure of a pressure-contact type semiconductor device according to another embodiment of the present invention.
FIG. 8 is a top view of a heat buffer plate 24 shown in FIG. 7A and FIG. 7B.
FIG. 9A and FIG. 9B are schematic views showing the structure of a pressure-contact type semiconductor device according to yet another embodiment of the present invention.
FIG. 10A and FIG. 10B are schematic views showing a structure example of a pressure-contact type semiconductor device (a comparison example).
FIG. 11A and FIG. 11B are views explaining the states when the pressure-contact type semiconductor device shown in FIG. 10A and FIG. 10B is to be used and after it is used for some time, respectively.

### DETAILED DESCRIPTION

### (Explanation on Embodiments)

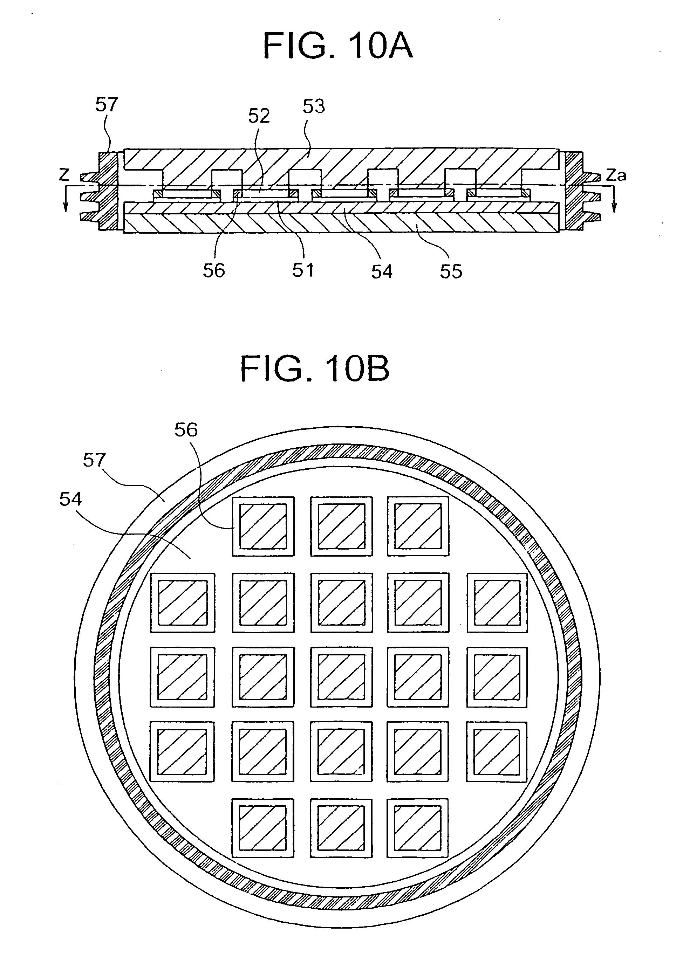

FIG. 10A and FIG. 10B are schematic views showing a structure example of a pressure-contact type semiconductor device as a comparison example. FIG. 10A shows a vertical sectional view thereof and FIG. 10B is a cross sectional view taken along the Z-Za line in FIG. 10A.

As shown in FIG. 10A and FIG. 10B, this pressure-contact type semiconductor device is so structured that a plurality of semiconductor chips 51 in a substantially rectangular shape are arranged in parallel, each having on front and rear surfaces thereof electrodes (not shown) to lead a principal current. As the semiconductor chips 51,pn junction diodes or switching elements having control terminals such asTGBTs are usable or those in which both are combined are usable. When the semiconductor chips 51 are switching elements having control terminals, the electrode being the control terminal is provided only on a part of the surface on the upper side in FIG. 10A of each of the semiconductor chips 51, and a not-shown conductive material is connected thereto to make the electrode electrically connectable to an external part through an insulative side enclosure 57.

On the surface on the upper side in FIG. 10A (the electrode on one side) of each of the semiconductor chips 51, a conductive heat buffer plate 52 is provided, and projections of a metal electrode plate 53 are in contact with surfaces on a further upper side of the heat buffer plates 52. On the surface on the lower side in FIG. 10A (the electrode on the other side) of each of the semiconductor chips 51, a common conductive heat buffer plate 54 is provided, and a metal electrode plate 55 is in contact with a surface on a further lower side of the entire heat buffer plate 54. Note that the shape of the abovementioned projections of the metal electrode plate 53 can be appropriately determined in consideration of plastic deformation caused by pressure-contact and heat generation of the semiconductor chips 51.

Each of the metal electrode plate 53, the heat buffer plate 54, and the metal electrode plate 55 has a periphery in a substantially circular shape, and surrounding these peripheries, an insulative side enclosure (made of, for example, ceramic) 57 is provided. The side enclosure 57 has a plurality of peripheral projections on an external lateral face thereof to elongate the creeping distance, thereby securing withstand voltage.

Each of the semiconductor chips 51 further has an insulative resin frame 56 in a rim portion thereof on the surface on the upper side in FIG. 10A. This resin frame 56 is intended for elongating the creeping distance between both of the electrodes on the semiconductor chips 51, thereby securing withstand voltage.

Incidentally, the diameter of the metal electrode plate 53 and so on is, for example, about 10 cm, and as the whole semiconductor device, the rated voltage can be, for example, about several thousands V and the rated current can be, for example, about 1000 A.

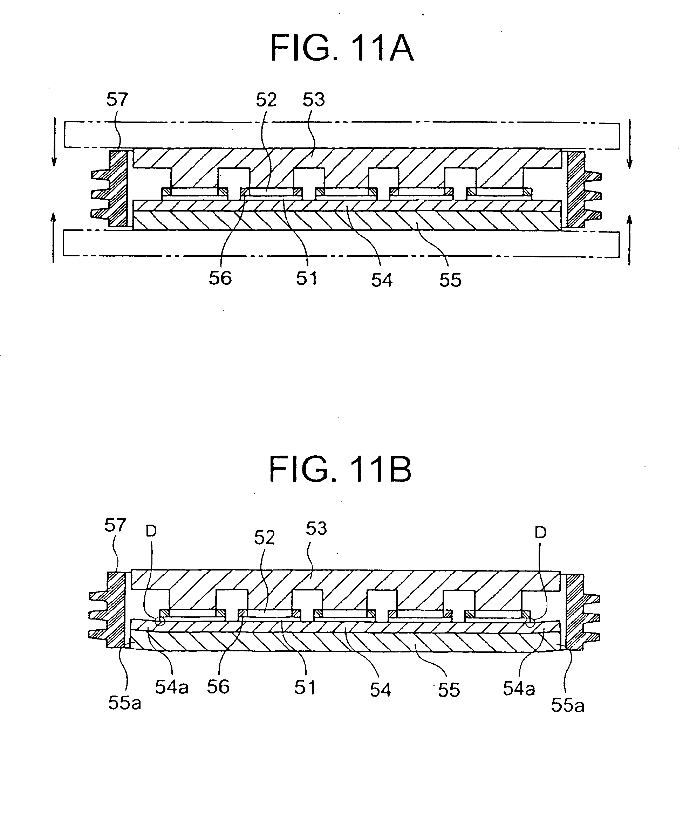

FIG. 11A and FIG. 11B are views explaining the states when the pressure-contact type semiconductor device shown in FIG. 10A and FIG. 10B is to be used and after it is used for some time, respectively. In FIG. 11A and FIG. 11B, the same reference numerals and symbols are used to designate the same components as those previously explained.

As shown in FIG. 11A, the metal electrode plates 53, 55 are given a pressure of, for example, several thousands kgf (several ten thousands N) in a facing direction by plates further provided on outer sides thereof. Through this process, the five components, namely, the metal electrode plate 53, the heat buffer plates 52, the semiconductor chips 51, the heat buffer plate 54, and the metal electrode plate 55 are brought into an electrically and thermally connected state while being uniformly given the pressure in a compression direction (that is, a uniform pressure-contact state). At this time, the effect of reducing heat resistance is obtainable. Moreover, since connecting metal such as solder or the like is not used for electrically connecting the components, satisfactory reliability is obtainable in a thermal cycle repeated when the device is in energizing and when it is not in energizing.

Heat generated by the semiconductor chips 51 is conveyed through the heat buffer plates 52, 54 and the metal electrode plates 53, 55 and the conveyed heat is heat-exchanged by, for example, water-cooled fins (not shown) provided outside the abovementioned pressure-contact plates. Through this process, the semiconductor device is cooled.

The heat buffer plates 52, 54 are made to have a thermal expansion coefficient only slightly different from that of silicon which is a main material of the semiconductor chips 51. This reduces a force in a shear direction caused by thermal expansion/contraction which occurs on contact surfaces between the semiconductor chips 51 and the heat buffer plates 52, 54, and makes the electrodes on the front and rear surfaces of the semiconductor chips 51 not liable to break. Incidentally, as the heat buffer plates 52, 54, for example, molybdenum, tungsten, or the like is usable.

As the metal electrode plates 53, 55, metal superior in heat conductivity and electrical conductivity, for example, copper (plated with, for example, nickel on a surface thereof for oxidation preventive purpose) is used. Copper has a very large thermal expansion coefficient compared with silicon, but since the metal electrode plates 53, 55 are thermally and electrically connected to the semiconductor chips 51 via the heat buffer plates 52, 54, an adverse effect given to the semiconductor chips 51 in the shear direction due to the thermal expansion/contraction of the metal electrode plates 53, 55 is greatly inhibited.

In the pressure-contact type semiconductor device as described above, the pressure contact and heatgeneration cause gradual thermal fatigue of especially the metal electrode plates, resulting in plastic deformation thereof. This state is shown in FIG. 11B. To be more specific, a peripheral portion 55a of the metal electrode plate 55 bends in a direction of the opposed metal electrode plate 53 and this state becomes a steady state. This is because the heat generation of the semiconductor chips 51 expands the metal electrode plates 55 in the pressure-contact direction so that a bending moment occurs in the peripheral portion 55a thereof not supported by the semiconductor chips 51, the heat buffer plates 52, and the metal electrode plate 55.

Here, even when this deformation of the peripheral portion 55a of the metal electrode plate 55 reaches the plastic deformation as described above, such a state can occur that a peripheral portion 54a of the heat buffer plate 54 is still in an elastic deformation state. This is because thermal deformation resistance differs between the metal electrode plate 55 and the heat buffer plate 54 since the former is made of, for example, copper while the latter is made of, for example molybdenum (in other words, copper is comparatively soft while molybdenum is comparatively hard). When the peripheral portion 54a of the heat buffer plate 54 is in the state of bending in the direction of the metal electrode plate 53 due to the elastic deformation, a stress is concentrated on an utmost outer side D of the periphery of the heat buffer plate 54 that is in contact with the semiconductor chips 51.

When such stress concentration occurs, uniformity of contact pressure between the semiconductor chips 51 and the heat buffer plate 54 in the pressure-contact state is lowered among the semiconductor chips 51 or inside the contact surface in each of the semiconductor chips 51. The deterioration of uniformity of the contact pressure causes difference in heat resistance among the semiconductor chips 51 or in each of the semiconductor chips 51, so that the semiconductor chips 51 are no longer in the state of uniform and parallel operation. Further, the occurrence of such tendency turns out to be a new factor of further depriving the semiconductor chips 51 of uniform and parallel operability. In other words, so-called deterioration due to thermal fatigue is caused, which is the state in which the semiconductor device does not operate as initially intended. Such a problem occurs conspicuously when multiple semiconductor chips are provided.

In contrast to the comparison example described above, an example of a pressure-contact type semiconductor device includes: a plurality of semiconductor chips; a heat buffer plate provided on one surface side of the plural semiconductor chips; and a metal electrode plate provided on the heat buffer plate on a side opposite the plural semiconductor chips, a surface thereof on the heat buffer plate side being recessed at any position not facing the plural semiconductor chips so as not to be in contact with the heat buffer plate. With this structure, even when the periphery of the metal electrode plate is plastically deformed toward the heat buffer plate side, the entire peripheral side of the heat buffer plate is not pressed so that the elastic deformation of the heat buffer plate is alleviated.

Consequently, uniformity of contact pressure between the heat buffer plate and the semiconductor chips is maintained over a longer period to enable enhancement in thermal fatigue resistance as a semiconductor device. Note that, in this application, the principal current mentioned below means not a current flowing through control electrodes but a current flowing between, for example, an anode and a cathode, an emitter and a collector, a source and a drain, and the like. The side face extension' also mentioned below means a side face of the metal electrode plate as a plate and a virtual surface which is formed by extending this side face.

A pressure-contact type semiconductor device according to the present invention includes: a plurality of semiconductor chips; a first heat buffer plate provided on one surface side of the plural semiconductor chips, a first metal electrode plate provided on the first heat buffer plate on a side opposite the plural semiconductor chips, a plurality of second heat buffer plates provided on the other surface sides of the plural semiconductor chips respectively, and a second metal electrode plate provided on the plural second heat buffer plates on a side opposite to the plural semiconductor chip sides and having projections facing and being in contact with the plural second heat buffer plates respectively and a pedestal portion being a base of the projections, characterised in that: to create a region which alleviates elastic deformation of the first heat buffer plate, the first heat buffer plate has a shape not extending outside a line connecting utmost outer positions of the plural semiconductor chips, and a surface of the first electrode plate opposite a surface facing the first heat buffer plate has a shape extending substantially outside the line connecting utmost outer positions of the plural semiconductor chips. With this structure, even when the periphery of the metal electrode plate is plastically deformed toward the heat buffer plate side, the influence of the plastic deformation is not directly given to the heat buffer plate so that elastic deformation of the heat buffer plate is alleviated.

Consequently, uniformity of contact pressure between the heat buffer plate and the semiconductor chips is maintained over a longer period to enable enhancement in thermal fatigue resistance as a semiconductor device.

As a form of an embodiment, the metal electrode plate is in contact with the heat buffer plate at positions facing the projections of the second metal electrode plate.

As another form of an embodiment, the heat buffer plate has a recession that is provided at a portion thereof not facing the plural semiconductor chips so as to extend in a direction penetrating the heat buffer plate and to reach the metal electrode plate.

As yet another form of an embodiment, the heat buffer plate has a single plate structure. When the single plate structure is kept, good assembility can be maintained as a pressure-contact type semiconductor device and deterioration also in terms of maintaining heat conductivity and electrical conductivity can be prevented.

As yet another form of an embodiment, the heat buffer plate may be constituted of a plurality of plates corresponding to the plural semiconductor chips respectively.

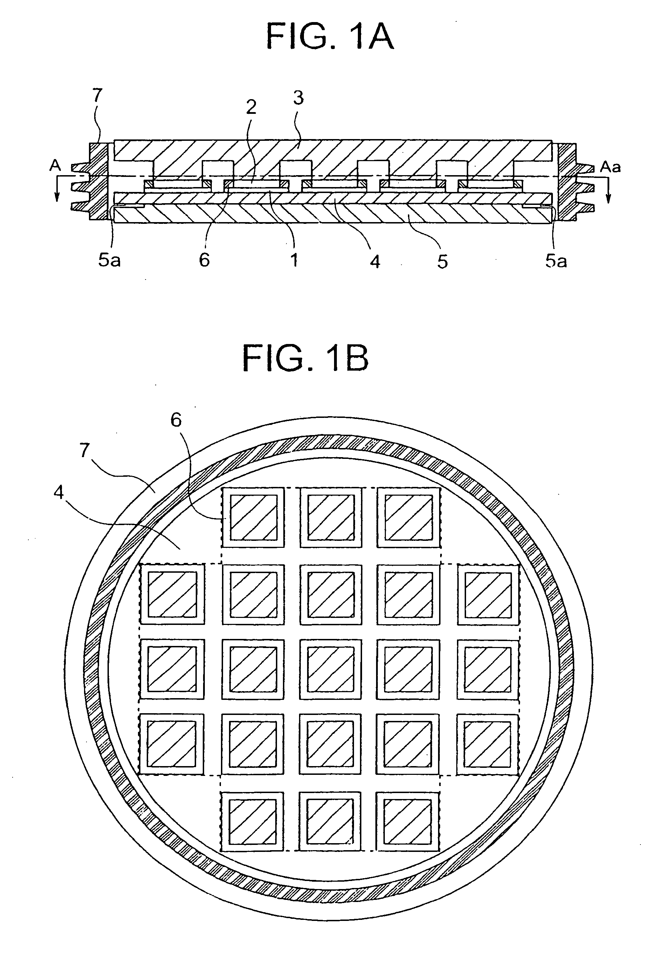

Based on the above, embodiments of the present invention and examples of pressure-contact semiconductor devices will be explained below with reference to the drawings. FIG. 1A and FIG. 1B are schematic views showing the structure of an example of a pressure-contact type semiconductor device. FIG. 1A shows a vertical section threof and FIG. 1B is a cross sectional view taken along the A-Aa line in FIG. 1A.

As shown in FIG. 1A and FIG. 1B, this pressure-contact type semiconductor device is so structured that a plurality of semiconductor chips 1 in a substantially rectangular shape are arranged in parallel, each having on front and rear surfaces thereof electrodes (not shown) to lead a principal current. As the semiconductor chips 1,pn junction diodes or switching elements having control terminals such asIGBTs are usable or those in which both are combined are usable. When the semiconductor chips 1 are switching elements having control terminals, the electrode being the control terminal is provided only on a part of the surface on the upper side in FIG. 1A of each of the semiconductor chips 1, and a not-shown conductive material is connected thereto to make the electrode electrically connectable to an external part through an insulative side enclosure 7. Incidentally, the semiconductor chips 1 are, for example, 500 µm in thickness.

On the surface on the upper side in FIG. 1A (the electrode on one side) of each of the semiconductor chips 1, a conductive heat buffer plate 2 is provided, and projections of a metal electrode plate 3 which project from a pedestal portion thereof are in contact with surfaces on a further upper side of the heat buffer plates 2. On the surface on the lower side in FIG. 1A (the electrode on the other side) of each of the semiconductor chips 1, a common conductive heat buffer plate 4 is provided, and a metal electrode plate 5 is in contact with a surface on a further lower side of the heat buffer plate 4. Each of the heat buffer plates 2 has a thickness of, for example, 1.5 mm, and the heat buffer plate 4 has a thickness of, for example, 2 mm. Note that the shape of the abovementioned projections of the metal electrode plate 3 can be appropriately determined in consideration of plastic deformation caused by pressure-contact and heat generation of the semiconductor chips 1.

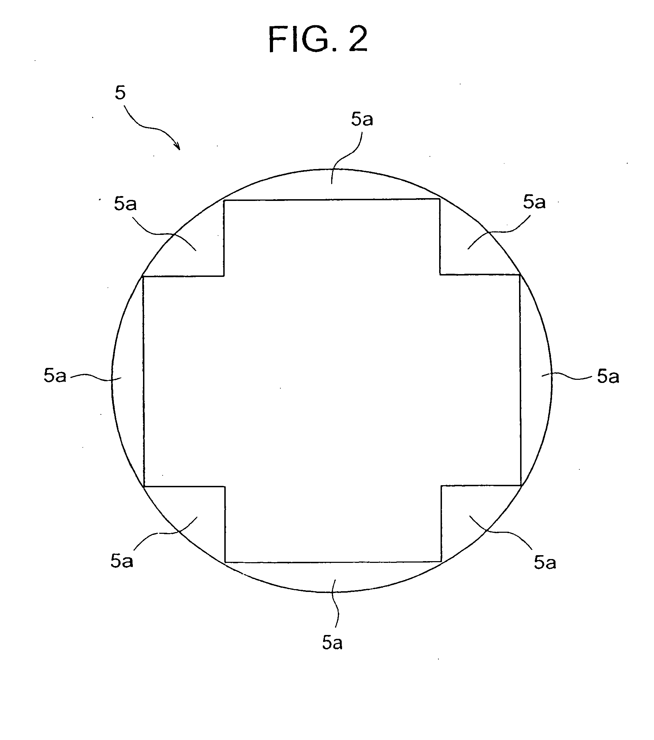

The metal electrode plate 5 is in contact with the heat buffer plate 4 and at the same time, has a portion 5a recessed from a contact surface thereof so as not to be in contact with the heat buffer plate 4. This portion 5a not in contact with the heat buffer plate 4 is so formed that it extends from a virtual cylinder surface which is formed by a side face extension of the metal electrode plate 5 and its end reaches the position in the periphery facing the semiconductor chips 1 via the heat buffer plate 4. A top view of the metal electrode plate 5 is shown in FIG. 2. In FIG. 2, the same reference numerals and symbols are used to designate portions corresponding to those in FIG. 1A and FIG. 1B.

Each of the metal electrode plate 3, the heat buffer plate 4, and the metal electrode plate 5 has a periphery in a substantially circular shape, and surrounding these peripheries, an insulative side enclosure (made of, for example, ceramic) 7 is provided. The side enclosure 7 has a plurality of peripheral projections on an external lateral face thereof to elongate the creeping distance, thereby securing withstand voltage.

Each of the semiconductor chips 1 further has an insulative resin frame 6 provided in a rim portion thereof on the surface on the upper side in FIG. 1A. This resin frame 6 is intended for elongating the creeping distance between both of the electrodes on the semiconductor chips 1, thereby securing withstand voltage.

Incidentally, the diameter of the metal electrode plate 3 and so on can be, for example, about 10 cm, and as the whole semiconductor device, the rated voltage can be, for example, about several thousands V and the rated current can be, for example, ) about 1000 A. Further, for example, when the semiconductor chips 1 are IGBTs, the metal electrode plate 5 is a collector side while the metal electrode plate 3 is an emitter side, and the principal current flows, for example, from the collector side to the emitter side, and when some of the semiconductor chips 1 are used as flywheel diodes, combined with the IGBTs, the upper surface and the lower surface in FIG. 1A of each of the flywheel diodes serve as an anode and a cathode respectively so that a conductive direction therein becomes opposite that in the IGBTs.

When the pressure-contact type semiconductor device explained above is to be used, the metal electrode plates 3, 5 are given a pressure of, for example, several thousands kgf (several ten thousands N) in a facing direction by plates further provided on an outer side thereof. Through this process, the five components, namely, the metal electrode plate 3, the heat buffer plates 2, the semiconductor chips 1, the heat buffer plate 4, and the metal electrode plate 5 are brought into an electrically and thermally connected state while being uniformly given the pressure in a compression direction. At this time, heat resistance can be reduced.

Heat generated by the semiconductor chips 1 is conveyed through the heat buffer plates 2, 4 and the metal electrode plates 3, 5 and the conveyed heat is heat-exchanged by, for example, water-cooled fins (not shown) provided outside the abovementioned pressure-contact plates. Through this process, the semiconductor device is cooled.

The heat buffer plates 2, 4 are made to have a thermal expansion coefficient only slightly different from that of silicon which is a main material of the semiconductor chips 1. This reduces a force in a shear direction caused by thermal expansion/contraction which occurs on contact surfaces between the semiconductor chips 1 and the heat buffer plates 2, 4, and makes the electrodes on the front and rear surfaces of the semiconductor chips 1 not liable to break. Incidentally, as the heat buffer plates 2, 4, for example, molybdenum, tungsten, or the like is usable.

As the metal electrode plates 3, 5, metal superior in heat conductivity and electrical conductivity, for example, copper (plated with, for example, nickel on a surface thereof for oxidation preventive purpose) is usable. Copper has a very large thermal expansion coefficient compared with silicon, but since the metal electrode plates 3, 5 are thermally and electrically connected to the semiconductor chips 1 via the heat buffer plates 2, 4, an adverse effect given to the semiconductor chips 1 in the shear direction due to the thermal expansion/contraction of the metal electrode plates 3, 5 is greatly inhibited.

In the pressure-contact type semiconductor device as structured above, even when the pressure-contact and heat generation cause gradual thermal fatigue of the metal electrode plate 5, resulting in plastic deformation of a peripheral portion thereof in the direction of the opposed metal electrode plate 3, the influence of the deformation is not given to the heat buffer plate 4. This is because the recessed portion 5a of the metal electrode plate 5 is provided at a portion thereof not facing the semiconductor chips 1 via the heat buffer plate 4 so that the heat buffer plate 4 is not deformed.

Consequently, uniformity of contact pressure between the heat buffer plate 4 and the semiconductor chips 1 is maintained among the chips and in each of the chips over a long period, resulting in good thermal fatigue resistance as a semiconductor device.

Note that, in order to obtain such an effect of enhancing the thermal fatigue resistance, it is not necessary to make an end of the recessed portion 5a of the metal electrode plate 5 precisely coincide with the position in the periphery facing the semiconductor chips 1 via the heat buffer plate 4, but this effect is also obtainable when the metal electrode plate 5 and its recessed portion 5a are formed in such a manner that a part of the metal electrode plate 5 not facing the semiconductor chips 1 is in contact with the heat buffer plate 4. This is because the elastic deformation of the heat buffer plate 4 caused by the plastic deformation of the metal electrode plate 5 is alleviated to a greater extent than that when no recessed portion is provided.

Further, the metal electrode plate 5 can be easily worked into the shape shown in FIG. 2 since the metal electrode plate 5 is made of a comparatively soft material, for example, copper. This is also advantageous in terms of cost and productivity. Incidentally, it is also possible to omit the heat buffer plates 2 on the upper side in FIG. 1A. This is because generally, one surface of the semiconductor chip 1 is easily abraded since a pattern is formed thereon while no pattern is formed on the other surface. It can be thought that the lifetime can be comparatively easily made long even with the abrasion when the surface not having the pattern formed thereon faces the upper side in the drawing.

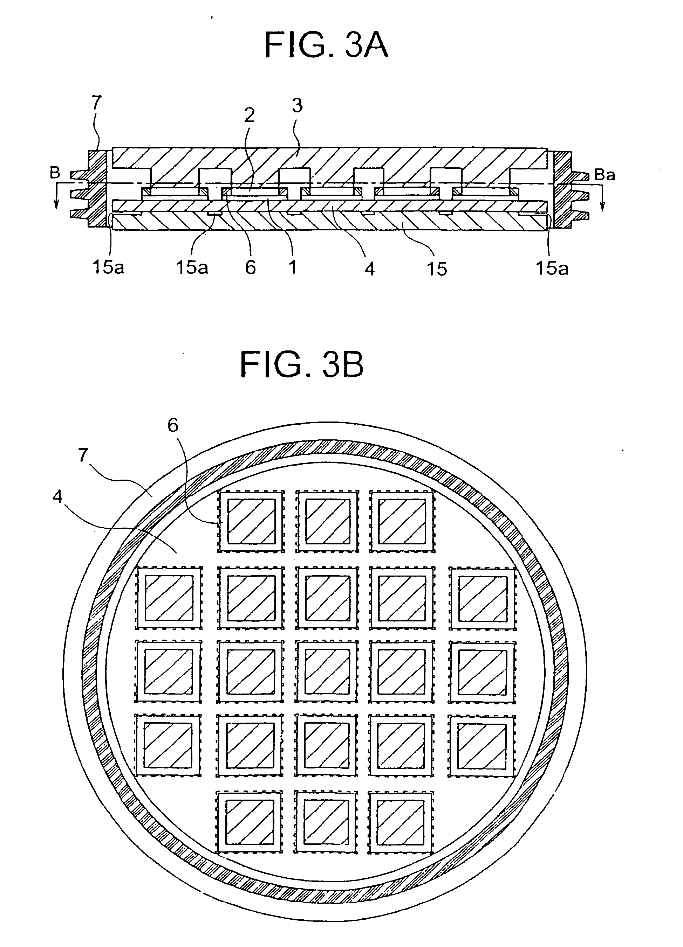

Next, another example of a pressure-contact type semiconductor device will be explained with reference to FIG. 3A and FIG. 3B. FIG. 3A shows a vertical section thereof and FIG. 3B is a cross sectional view taken along the B-Ba line in FIG. 3A. In FIG. 3A and FIG. 3B, the same reference numerals and symbols are used to designate the same components as those in the drawings previously explained. Duplicate explanation will be omitted below.

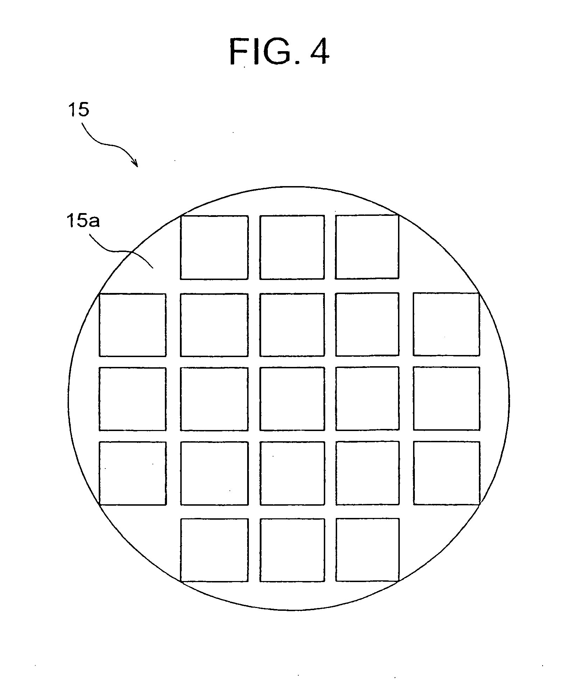

In this device, a portion 15a of a metal electrode plate 15 not in contact with a heat buffer plate 4 is made larger than the corresponding portion in the device shown in FIG. 1A and FIG. 1B. Specifically, as shown in FIG. 3A and FIG. 3B, this portion 15a not in contact with the heat buffer plate 4 is formed in such a manner that it extends from a virtual cylinder face formed by a side face extension of the metal electrode plate 15 and its end reaches the position in the periphery facing semiconductor chips 1 via the heat buffer plate 4, and is provided also in portions between the semiconductor chips 1 that are portions not facing the semiconductor chips 1. A top view of the metal electrode plate 15 is shown in FIG. 4. In FIG. 4, the same reference numerals and symbols are used to designate portions corresponding to those in FIG. 3A and FIG. 3B. Other attributes, properties, and so on of the metal electrode plate 15 are the same as those of the metal electrode plate 5 in the device shown in FIG. 1A and FIG. 1B.

In the pressure-contact type semiconductor device as described above, substantially the same effect of enhancing thermal fatigue resistance as that in the device shown in FIG. 1A and FIG. 1B is obtainable. In addition, it can also cope with the case when the metal electrode plate 15 is softer to be plastically deformed even in the portions between the semiconductor chips 1 not facing the semiconductor chips 1 and the plastic deformation may possibly induce elastic deformation of the heat buffer plate 4. In other words, also in such a case, the deformation of the heat buffer plate 4 is avoided owing to the recessed portion 15a.

Consequently, uniformity of contact pressure between the heat buffer plate 4 and the semiconductor chips 1 is maintained over a long period both among the chips and in each of the chips, resulting in good thermal fatigue resistance as a semiconductor device.

Further,similarly to the device shown in FIG. 1A and FIG. 1B, the metal electrode plate 15 can be easily worked into the shape shown in FIG. 4 since the metal electrode plate 15 is made of a comparatively soft material, for example, copper. This is also advantageous in terms of cost and productivity.

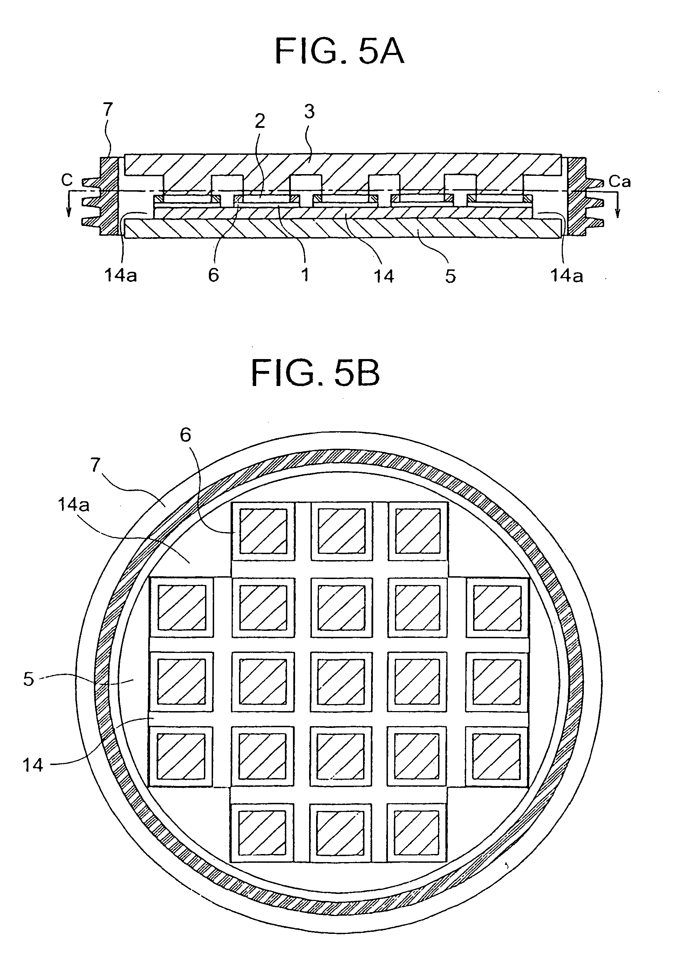

Next, a pressure-contact type semiconductor device according to another embodiment of the present invention will be explained with reference to FIG. 5A and FIG. 5B. These drawings are schematic views showing the structure of the pressure-contact type semiconductor device according to this embodiment of the present invention. FIG. 5A shows a vertical section thereof and FIG. 5B is a cross sectional view taken along the C-Ca line in FIG. 5A. In FIG. 5A and FIG. 5B, the same reference numerals and symbols are used to designate the same components as those in the drawings previously explained. Duplicate explanation will be omitted below.

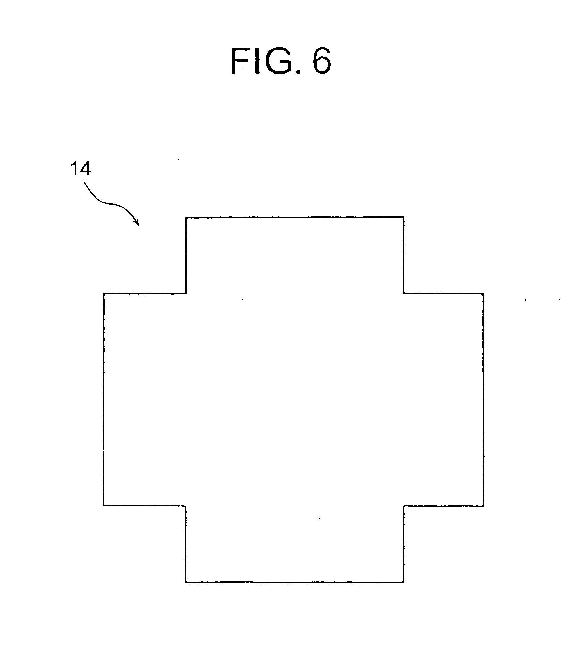

In this embodiment, a metal electrode plate 5 has no recessed portion. Instead, a heat buffer plate 14 has a space portion 14a provided at a portion thereof not facing semiconductor chips 1, the space portion 14a extending in a direction penetrating the heat buffer plate 14 to reach the metal electrode plate 5. The space portion 14a is formed in such a manner that it extends from a virtual cylinder surface formed by a side face extension of the metal electrode plate 5 and its end reaches the position in the periphery facing the semiconductor chips 1. A top view of the heat buffer plate 14 is shown in FIG. 6. In FIG. 6, the same reference numerals and symbols are used to designate portions corresponding to those in FIG. 5A and FIG. 5B. Other attributes, properties, and so on of the heat buffer plate 14 are the same as those of the heat buffer plate 4 in the device shown in FIG. 1A and FIG. 1B.

In such a pressure-contact type semiconductor device, even when pressure-contact and heat generation cause gradual thermal fatigue of the metal electrode plate 5, thereby causing plastic deformation of a peripheral portion thereof in a direction of an opposed metal electrode plate 3, the heat buffer plate 14 is not given the influence of this deformation, either. This is because the heat buffer plate 14 does not extend outside the semiconductor chips 1.

Consequently, uniformity of contact pressure between the heat buffer plate 14 and the semiconductor chips 1 is maintained over a long period both among the chips and in each of the chips, resulting in good thermal fatigue resistance as a semiconductor device.

Note that, in order to obtain such an effect of enhancing the thermal fatigue resistance, it is not necessary to make an end of the space portion 14a of the heat buffer plate 14 precisely coincide with ends of the semiconductor chips 1, but this effect is also obtainable when the space portion 14a is provided in such a manner that it extends outward from the position slightly outside the semiconductor chips 1. This is because the elastic deformation of the heat buffer plate 14 caused by the plastic deformation of the metal electrode plate 5 is alleviated to a greater extent than that in the case when no space portion 14a is provided.

In this embodiment, a plane shape of the heat buffer plate 14 is not circular. Since the heat buffer plate 14 is made of harder metal, workability is inferior to that when it is circular (the device shown in FIG. 1A, FIG. 1B, FIG. 3A, and FIG. 3B), but when the single plate structure is kept, good assembility can be maintained as a semiconductor device.

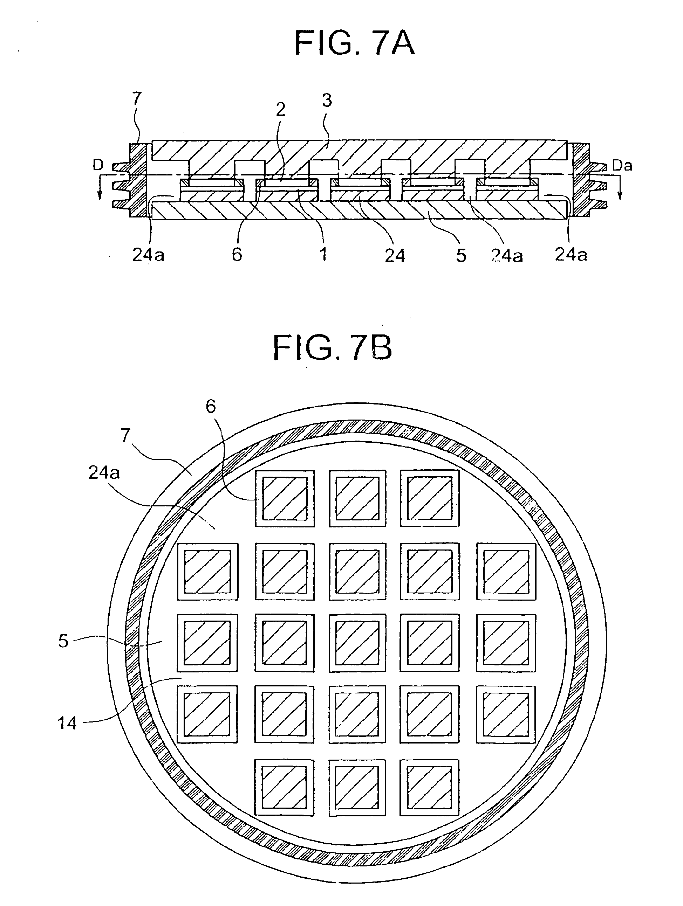

Next, a pressure-contact type semiconductor device according to yet another embodiment of the present invention will be explained with reference to FIG. 7A and FIG. 7B. These drawings are schematic views showing the structure of the pressure-contact type semiconductor device according to yet another embodiment of the present invention. FIG. 7A shows a vertical section thereof and FIG. 7B is a cross sectional view taken along the D-Da line in FIG. 7A. In FIG. 7A and FIG. 7B, the same reference numerals and symbols are used to designate the same components as those in the drawings previously explained. Duplicate explanation will be omitted below.

In this embodiment, a heat buffer plate 24 constituted not of a single plate but of an aggregate of rectangular plates is used, instead of the heat buffer plate 14 constituted of the single plate shown in FIG. 5A and FIG. 5B. In this case, workability is better since the shape of each portion of the heat buffer plate 24 is simpler. Such a heat buffer plate 24 as the aggregate takes such a form that the heat buffer plate as portions not facing semiconductor chips 1 does not exist, and in this sense, it can be also said that a space portion 24a is made larger than the space portion 14a of the heat buffer plate 14 shown in FIG. 5A and FIG. 5B.

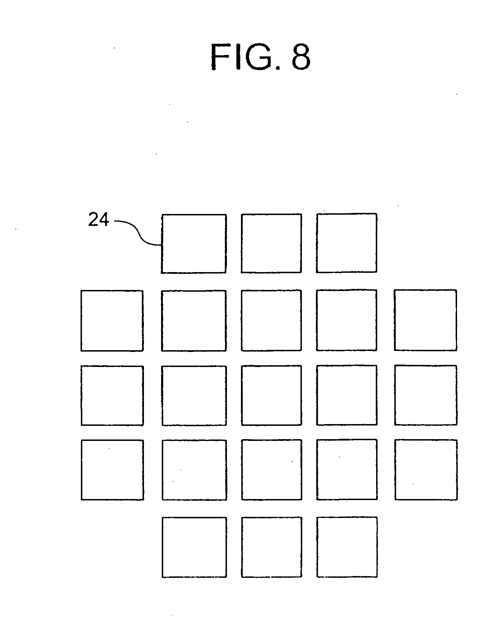

A top view of the heat buffer plate 24 as the aggregate is shown in FIG. 8. In FIG. 8, the same reference numerals and symbols are used to designate portions corresponding to those in FIG. 7A and FIG. 7B. Other attributes, properties, and so on of the heat buffer plate 24 are the same as those of the heat buffer plate 4 in the device shown in FIG. 1A and FIG. 1B or the heat buffer plate 14 in the device shown in FIG. 5A and FIG. 5B.

In the pressure-contact type semiconductor device as structured above, substantially the same effect of enhancing thermal fatigueresistance as that in the embodiment shown in FIG. 5A and FIG. 5B is obtainable. In addition, it can also cope with the case when a metal electrode plate 5 is softer to be plastically deformed even in portions between the semiconductor chips 1 not facing the semiconductor chips 1 and the plastic deformation may possibly induce elastic deformation of the heat buffer plate. In other words, also in such a case, the deformation of the heat buffer plate 24 is avoided owing to the space portion 24a.

Consequently, uniformity of contact pressure between the heat buffer plate 24 and the semiconductor chips 1 is maintained over a long period both among the chips and in each of the chips, resulting in better thermal fatigue resistance as a semiconductor device.

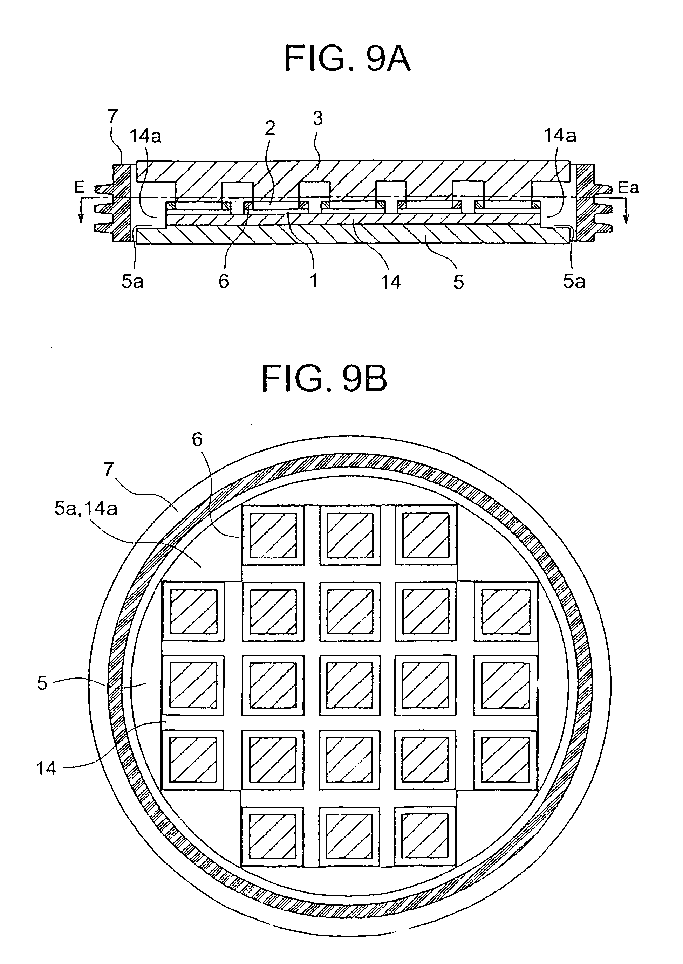

Next, a pressure-contact type semiconductor device according to yet another embodiment of the present invention will be explained with reference to FIG. 9A and FIG. 9B. These drawings are schematic views showing the structure of the pressure-contact type semiconductor device according to yet another embodiment of the present invention. FIG. 9A shows a vertical section thereof and FIG. 9B is a cross sectional view taken along the E-Ea line in FIG. 9A. In FIG. 9A and FIG. 9B, the same reference numerals and symbols are used to designate the same components as those in the drawings previously explained. Duplicate explanation will be omitted below.

In this embodiment, a recessed portion (recessed portion 5a) is provided in a metal electrode plate 5 and in addition, a space portion 14a reaching the metal electrode plate 5 is also provided in a heat buffer plate 14 in a portion thereof not facing semiconductor chips 1 in a direction penetrating the heat buffer plate 14. The recessed portion 5a of the metal electrode plate 5 is the same as that in the device shown in FIG. 1A and FIG. 1B, and the space portion 14a of the heat buffer plate 14 is the same as that in the embodiment shown in FIG. 5A and FIG. 5B.

In such pressure-contact type semiconductor device, the effects in the device shown in FIG. 1A and FIG. 1B and in the embodiment shown in FIG. 5A and FIG. 5B explained above work together to prevent the heat buffer plate 14 from receiving the influence of plastic deformation of a metal electrode plate 5. Consequently, uniformity of contact pressure between the heat buffer plate 14 and the semiconductor chips 1 is maintained over a long period both among the chips and in each of the chips, resulting in better thermal fatigue resistance as a pressure-contact type semiconductor device.

It is to be understood that the present invention is not intended to be limited to the specific forms described here with reference to the drawings and all changes an modifications which come within the meaning and range of equivalency of the following claims are embraced therein.

## Claims

1. A pressure-contact type semiconductor device, comprising:
a plurality of semiconductor chips (1);
a first heat buffer plate (14, 24) provided on one surface side of the plural semiconductor chips;
a first metal electrode plate (5) provided on the first heat buffer plate on a side opposite the plural semiconductor chips;
a plurality of second heat buffer plates (2) provided on the other surface sides of the plural semiconductor chips (1) respectively; and
a second metal electrode plate (3) provided on the plural second heat buffer plates on a side opposite to the plural semiconductor chip sides and having projections facing and being in contact with the plural second heat buffer plates respectively and a pedestal portion being a base of the projections,
**characterised in that**:
to create a region which alleviates elastic deformation of the first heat buffer plate, the first heat buffer plate (14, 24) has a shape not extending outside a line connecting utmost outer positions of the plural semiconductor chips (1); and
a surface of the first electrode plate (5) opposite a surface facing the first heat buffer plate (14, 24) has a shape extending substantially outside the line connecting utmost outer positions of the plural semiconductor chips (1).

2. A pressure-contact type semiconductor device as set forth in claim 1, wherein the first metal electrode plate is in contact with the first heat buffer plate at positions facing the projections of the second metal electrode plate.

3. A pressure-contact type semiconductor device as set forth in claim 1, wherein a peripheral shape of the first heat buffer plate falls inside a peripheral shape of the first metal electrode plate.

4. A pressure-contact type semiconductor device as set forth in claim 1, wherein the first heat buffer plate has a recession (24a) at a position not facing the plural semiconductor chips thereby exposing the first metal electrode plate.

5. A pressure-contact type semiconductor device as set forth in claim 1, wherein the first heat buffer plate has a single plate structure.

## Patentansprüche

1. Halbleitervorrichtung vom Druckkontakttyp, umfassend:
eine Mehrzahl von Halbleiter-Chips (1);
eine erste Wärmepufferplatte (14, 24) die auf einer Oberflächenseite der mehreren Halbleiter-Chips vorgesehen ist;
eine erste Metallelektrodenplatte (5), die auf der ersten Wärmepufferplatte auf einer Seite gegenüberliegend den mehreren Halbleiter-Chips vorgesehen ist;
eine Mehrzahl von zweiten Wärmepufferplatten (2), die jeweils auf den anderen Oberflächenseiten der mehreren Halbleiter-Chips (1) angeordnet sind; und
eine zweite Metallelektrodenplatte (3), die auf den mehreren zweiten Wärmepufferplatten auf einer Seite gegenüber den mehreren Halbleiter-Chip-Seiten vorgesehen ist und Vorsprünge aufweist, die jeweils zu den mehreren zweiten Wärmepufferplatten weisen und in Kontakt mit ihnen sind und einem Sockelbereich, der eine Basis der Vorsprünge ist,
**dadurch gekennzeichnet, dass**
zur Erzeugung eines Bereichs, welcher eine elastische Deformation der ersten Wärmepufferplatte fördert, die erste Wärmepufferplatte (14, 24) eine Form aufweist, die sich nicht außerhalb einer Linie erstreckt, welche die alleräußersten Positionen der mehreren Halbleiter-Chips (1) verbindet; und
eine Oberfläche der ersten Elektrodenplatte (5) gegenüber einer Oberfläche, welche zu der ersten Wärmepufferplatte (14, 24) weist, eine Form aufweist, die sich im Wesentlichen außerhalb der Linie erstreckt, welche die alleräußersten Positionen der mehreren Halbleiter-Chips (1) verbindet.

2. Halbleitervorrichtung vom Druckkontakttyp gemäß Anspruch 1, wobei die erste Metallelektrodenplatte in Kontakt mit der ersten Wärmepufferplatte an Positionen steht, welche zu den Vorsprüngen der zweiten Metallelektrodenplatte weisen.

3. Halbleitervorrichtung vom Druckkontakttyp gemäß Anspruch 1, wobei eine Umrissform der ersten Wärmepufferplatte innerhalb einer Umrissform der ersten Metallelektrodenplatte fällt.

4. Halbleitervorrichtung vom Druckkontakttyp gemäß Anspruch 1, wobei die erste Wärmepufferplatte eine Vertiefung (24a) an einer Position aufweist, die nicht zu den mehreren Halbleiter-Chips weist, wodurch die erste Metallelektrodenplatte exponiert wird.

5. Halbleitervorrichtung vom Druckkontakttyp gemäß Anspruch 1, wobei die erste Wärmepufferplatte eine einzelne Plattenstruktur aufweist.

## Revendications

1. Dispositif semi-conducteur de type contact à pression, comprenant:
une pluralité de puces semi-conductrices (1) ;
une première plaque d'amortisseur thermique (14, 24) disposée sur un côté de surface des multiples puces semi-conductrices
une première plaque d'électrode métallique (5) disposée sur la première plaque d'amortisseur thermique sur un côté opposé aux multiples puces semi-conductrices ;
une pluralité de secondes plaques d'amortisseur thermique (2) disposées respectivement sur les autres côtés de surface des multiples puces semi-conductrices (1) ; et
une seconde plaque d'électrode métallique (3) disposée sur les multiples secondes plaques d'amortisseur thermique sur un côté opposé aux côtés des multiples puces semi-conductrices et ayant des saillies faisant face aux et étant respectivement en contact avec les multiples secondes plaques d'amortisseur thermique et une partie de socle étant une base des saillies,
**caractérisé en ce que** :
afin de créer une zone qui réduit la déformation élastique de la première plaque d'amortisseur thermique, la première plaque d'amortisseur thermique (14, 24) a une forme ne dépassant pas une ligne reliant les positions les plus externes des multiples puces semi-conductrices (1) ; et
une surface de la première plaque d'électrode (5) opposée à une surface faisant face à la première plaque d'amortisseur thermique (14, 24) a une forme dépassant sensiblement la ligne reliant les positions les plus externes des multiples puces semi-conductrices (1).

2. Dispositif semi-conducteur de type contact à pression selon la revendication 1, dans lequel la première plaque d'électrode métallique est en contact avec la première plaque d'amortisseur thermique au niveau de positions faisant face aux saillies de la seconde plaque d'électrode métallique.

3. Dispositif semi-conducteur de type contact à pression selon la revendication 1, dans lequel une forme périphérique de la première plaque d'amortisseur thermique se trouve à l'intérieur d'une forme périphérique de la première plaque d'électrode métallique.

4. Dispositif semi-conducteur de type contact à pression selon la revendication 1, dans lequel la première plaque d'amortisseur thermique a un renfoncement (24a) au niveau d'une position ne faisant pas face aux multiples puces semi-conductrices, mettant ainsi à nu la première plaque d'électrode métallique.

5. Dispositif semi-conducteur de type contact à pression selon la revendication 1, dans lequel la première plaque d'amortisseur thermique a une structure en une seule plaque.
